# EUROPEAN PATENT SPECIFICATION

(11) **EP 2 725 586 B1**
(45) Date of publication and mention of the grant of the patent: **04.04.2018**
(21) Application number: 13808940.4
(22) Date of filing: 26.06.2013
(51) Int. Cl.: H01B 12/06, H01L 39/24

(54) **SUPERCONDUCTING WIRE**
SUPRALEITENDER DRAHT
FIL SUPRACONDUCTEUR

(30) Priority: 27.06.2012 JP 2012144181
(43) Date of publication of application: 30.04.2014
(73) Proprietor: Furukawa Electric Co., Ltd., Chiyoda-ku Tokyo 100-8322 (JP)
(72) Inventor: HIGUCHI, Masaru, Tokyo 100-8322 (JP); SAKAMOTO, Hisaki, Tokyo 100-8322 (JP); ORITA, Nobuaki, Tokyo 100-8322 (JP); SHIBAYAMA, Norihisa, Tokyo 100-8322 (JP)
(74) Representative: Horn Kleimann Waitzhofer Patentanwälte PartG mbB
(86) International application number: PCT/JP2013/067490
(87) International publication number: WO 2014/003049

(56) References cited:
- EP-A1- 1 653 484
- WO-A1-2007/080876
- JP-A- 2006 027 958
- JP-A- 2007 115 561
- JP-A- 2011 096 509
- JP-A- 2011 096 510
- JP-A- 2012 038 653
- JP-A- 2012 064 519
- SHEEHAN C ET AL: "Solution deposition planarization of long-length flexible substrates", APPLIED PHYSICS LETTERS, vol. 98, 15 February 2011 (2011-02-15), pages 071907/1-3, XP012139494, ISSN: 0003-6951, DOI: 10.1063/1.3554754
- TOMOV R I ET AL: "Pulsed laser deposition of epitaxial YBa2Cu3O7-y/oxide multilayers onto textured NiFe substrates for coated conductor applications", SUPERCONDUCTOR SCIENCE AND TECHNOLOGY, vol. 15, no. 4, 1 March 2002 (2002-03-01), pages 598-605, XP002609583, ISSN: 0953-2048, DOI: 10.1088/0953-2048/15/4/320 [retrieved on 2002-03-01]

## Description

### Technical Field

The present invention relates to a superconducting wire with an intermediate layer and a superconducting layer both deposited on a substrate, and in particular, to a superconducting wire including an intermediate layer deposited therein and having smoothness higher than surface smoothness of a substrate to allow a high critical current property (high critical current) to be achieved.

### Background Art

A common superconducting wire is structured as follows. For example, a metal tape is used as a substrate in order to provide strength, flexibility, and the like needed for wires. An oxide layer (one or more layers) is deposited on the substrate to form an intermediate layer. Then, a superconducting layer formed of an oxide superconductor is deposited on the intermediate layer. Moreover, a protective layer (also referred to as a stabilizing layer) is deposited on the superconducting layer to, for example, protect the superconducting layer and diverge local heat.

A critical current in the superconducting wire depends on the in-plane orientation of the superconducting layer. In the above-described superconducting wire, the in-plane orientation of the superconducting layer is affected by the surface smoothness (surface roughness) and in-plane orientation of the intermediate layer. The surface smoothness of the intermediate layer is affected by the surface smoothness of the substrate.

Thus, to provide the intermediate layer with appropriate surface smoothness (for example, an arithmetic average roughness Ra of 1 nm to 2 nm or less. The arithmetic average roughness Ra is hereinafter simply referred to as the "roughness Ra".), the substrate needs to be smoothed by mechanical polishing and/or electropolishing. However, in common machine polishing, the smoothness of the substrate is undeniably likely to be locally insufficient.

An IBAD method (Ion Beam Assisted Deposition), a MOD method (Metal Organic Deposition), and the like are known as techniques for forming an intermediate layer with the desired surface roughness and in-plane orientation. The MOD method, which is a non-vacuum process, needs lower costs than the IBAD method, which is a vacuum process. Furthermore, a sputtering method and a deposition method have difficulty making the surface smoothness of the intermediate layer higher than the surface smoothness of the substrate. Thus, the substrate needs to inherently have appropriate smoothness.

Thus, Patent Literature 1 discloses a technique for smoothing the surface of a substrate by electropolishing, which is a smoothing method tending to avoid locally insufficient smoothness, and then depositing an intermediate layer by the MOD method, in order to obtain a high critical current in the superconducting wire. Furthermore, Patent Literature 2 discloses a technique for depositing a superconducting wire, involving providing dip coating on an electropolished substrate and then depositing an intermediate layer and the like by the IBAD method. Patent Literature 3 teaches mechanochemical planarization of the substrate to maximum peak-valley roughness R_{P-V} of at most 150 nm, examplary values lying between 34 nm and 143 nm.

### Citation List

### Patent Literature:

[Patent Literature 1] Japanese Patent Laid-Open No. 2011-096510
[Patent Literature 2] U.S. Patent No. 8,088,503
[Patent Literature 3] EP 1 653 484 A1

### Non-Patent Literature:

Sheehan et al.: "Solution deposition planarization of long-length flexible substrates", APPLIED PHYSICS LETTERS, vol. 98, 071907/1-3, 15 February 2011 discloses a substrate with an rms roughness of 9.8 nm.

### Summary of Invention

### Technical Problem:

However, disadvantageously, a step of polishing the substrate is a factor increasing manufacturing costs of the superconducting wire, and the mechanical polishing undeniably suffers reduced yield due to locally inappropriate polishing. Furthermore, the increased surface smoothness of the substrate reduces the adhesive strength between the substrate and the intermediate layer (hereinafter sometimes simply referred to as the adhesive strength). That is, the improvement of both the surface smoothness of the substrate and the adhesive strength has definite limits.

Thus, an object of the present invention is to provide a superconducting wire which allows an intermediate layer with appropriate surface smoothness to be deposited to provide an appropriate critical current property and which also allows high adhesive strength to be achieved.

### Solution to Problem:

To accomplish the object, a superconducting wire according to the present invention includes a substrate having a deposition plane with a surface having a maximum height roughness Rz of 10 nm to 18 nm, an intermediate layer having a first intermediate layer with a coating film formed on the deposition plane and a second biaxially oriented intermediate layer formed on the first intermediate layer, and an oxide superconducting layer deposited on the intermediate layer.

In the superconducting wire, the first intermediate layer includes a plurality of thin coating films, and an outermost thin coating film layer formed at an outermost surface of the intermediate layer is formed to be thinner than a first thin coating film layer formed on the deposition plane. This enables the surface smoothness of the first intermediate layer to be made more appropriate than the surface smoothness of the substrate with the first intermediate layer coated thereon. Furthermore, a material solution used to deposit the outermost thin coating film layer formed at the outermost surface of the first intermediate layer has a lower viscosity than the material solution used to deposit the first thin coating film layer formed on the deposition plane. Thus, the first intermediate layer has more appropriate surface smoothness than the substrate.

Preferably, each of the plurality of thin coating film layers is formed such that a film thickness of the thin coating film layer decreases with increasing distance from the surface of the deposition plane. Furthermore, the material solution used for deposition preferably has a viscosity decreasing with increasing distance from the substrate. This further improves the surface smoothness of the first intermediate layer.

In this case, the adhesive strength on the surface of the substrate increases consistently with a roughness Rz due to what is called an anchor effect. Thus, the surface preferably has a maximum height roughness Rz of 10 nm or more. Furthermore, the surface smoothness of the first intermediate layer affects a critical current flowing through the superconducting layer. Hence, the surface of the first intermediate layer preferably has an arithmetic average roughness Ra of 5 nm or less.

In the superconducting wire, the first intermediate layer with the appropriate surface smoothness is deposited on a substrate with a substrate surface having lower smoothness than a conventional substrate surface. Thus, even if the substrate is formed by rolling, that is, the substrate has only surface smoothness that can be achieved by rolling, the first intermediate layer with the appropriate surface smoothness can be deposited. Consequently, an appropriate critical current property can be achieved.

The thin coating film layer can be deposited by the MOD method so as to have a film thickness of, for example, 300 nm to 1,000 nm. The MOD method is a non-vacuum process of coating the substrate with a material solution with an organic metal compound dissolved therein and heating the substrate to cause pyrolysis, thus depositing a thin film on the substrate. The MOD method enables high-speed deposition at low costs and is thus suitable for manufacturing an elongate tape-like oxide superconducting wire. Furthermore, the second intermediate layer can be formed by the ion beam assisted deposition method. In this case, the thin coating film layer is preferably an amorphous thin film.

### Advantageous Effects of Invention:

The present invention can provide a superconducting wire that provides the intermediate layer with the appropriate surface smoothness while maintaining high adhesive strength between the substrate and the intermediate layer based on the surface smoothness of the substrate, allowing a high critical current to be obtained.

Furthermore, the present invention allows an intermediate layer with high surface smoothness to be deposited, eliminating the need to polish the substrate. For example, a first intermediate layer can be formed without the need to polish a substrate formed by rolling. Thus, the manufacturing costs of the superconducting wire can be reduced.

Of course, even when the substrate is polished, an intermediate layer with high surface smoothness can be formed on a substrate with relatively low surface smoothness. Thus, the manufacturing costs of the superconducting wire can be reduced.

### Brief Description of Drawings

Figure 1 is a diagram illustrating a general configuration of a superconducting wire according to an embodiment of the present invention.
Figure 2 is a diagram illustrating an example of a first intermediate layer in the superconducting wire shown in Figure 1.
Figure 3 is a diagram illustrating a general sectional configuration of the superconducting wire shown in Figure 1.
Figure 4 is a graph showing an example of relations between a critical current and the surface roughness Ra (bed layer Ra) of the first intermediate layer in the superconducting wire shown in Figure 1.
Figure 5 is a graph showing an example of relations between adhesive strength and a substrate surface roughness Rz (substrate Rz) in the superconducting wire shown in Figure 1.

### Description of Embodiments

A superconducting wire according to the present invention will be described below with reference to the drawings and tables.

### General configuration of the superconducting wire

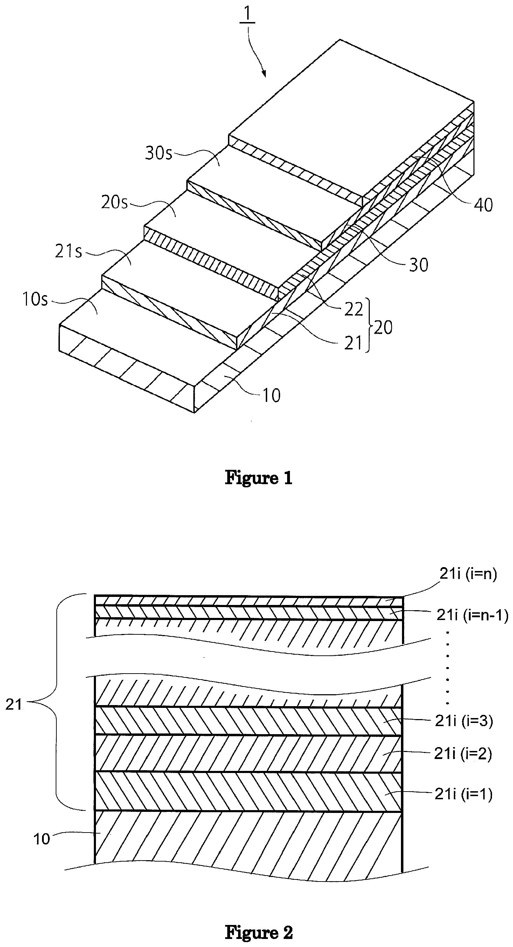

Figure 1 shows a general configuration of a superconducting wire 1 according to an embodiment of the present invention. The superconducting wire 1 has a configuration to include a substrate 10 and an intermediate layer 20, a superconducting layer (oxide superconducting layer) 30, and a protective layer 40 deposited on the substrate 10 in this order.

### Substrate

The substrate 10 is formed like a tape, and at least one surface of a principal plane of the substrate 10 (surface) is a deposition plane. The substrate 10 is formed of non-oriented metal, non-oriented ceramic, or the like which has low magnetism and high strength and heat resistance. Examples of the metal material used for the substrate include metals such as Co, Cu, Ni, Ti, Mo, Nb, Ta, W, Mn, Fe, Ag, and Cr and alloys thereof, which are excellent in strength and heat resistance (the metals and the alloys are hereinafter sometimes simply referred to as the "metal"). Particularly preferable metal materials include stainless steel, HASTELLOY (registered trade mark), and other nickel alloys, which are excellent in corrosion resistance and heat resistance. Furthermore, any of various types of ceramics may be provided on any of these various metal materials. Additionally, a material for a ceramic substrate may be, for example, MgO, SrTiO3, or yttria-stabilized zirconia.

When the substrate 10 is metal, the substrate 10 can be formed to have a desired width, a desired film thickness, and a desired length, while rolling, for example, a metal plate wound around a reel using a rolling mill roll. The surface of the substrate 10 can be formed to have a desired roughness (for example, a roughness Rz of 10 nm or more) by appropriately controlling the above-described rolling step, for example, appropriately controlling the number of rolling operations using the rolling mill roll, the smoothness of a surface of the rolling mill roll, a rolling pressure, the temperature at the time of the rolling step, and the like, in consideration of the component composition of the metal plate.

### Intermediate layer

The intermediate layer 20 is deposited on a surface (deposition plane) 10s of the substrate 10 so as to intervene between the substrate 10 and the superconducting layer 30, thus achieving high in-plane orientation in the superconducting layer 30. Furthermore, the intermediate layer 20 has a function as a buffer layer between the substrate 10 and the superconducting layer 30. For example, the intermediate layer 20 restrains elements contained in the substrate 10 from diffusing into the superconducting layer 30 and further mitigates the adverse effects of a difference in the coefficient of thermal expansion between the substrate 10 and the superconducting layer 30. The intermediate layer 20 has a first intermediate layer 21 and a second intermediate layer 22. The first intermediate layer 21 is deposited on the surface (deposition plane) 10s of the substrate 10. The second intermediate layer 22 is deposited on a surface 21s of the first intermediate layer 21.

"Deposited on the surface (deposition plane) 10s of the substrate 10" means that the first intermediate layer 21 is formed directly on the surface (deposition plane) 10s after molding of the substrate 10 and that the first intermediate layer 21 is formed on the surface (deposition plane) 10s having undergone a certain processing step or the like after molding of the substrate 10. That is, "on the surface" and "on the substrate" according to the present invention are synonymous with the "on the surface (deposition plane) 10s".

### First intermediate layer

The first intermediate layer 21 is deposited by, for example, the MOD method, by coating a material solution on the surface 10s of the substrate 10. At this time, the coated material solution is a solution of metallic organic acid salt containing any of rare earth oxides such as Gd₂Tr₂O_{7-δ} (-1 < δ < 1; hereinafter sometimes referred to as "GZO"), YAlO₃ (yttrium aluminate), YSZ (yttria-stabilized zirconia), Y₂O₃, Gd₂O₃, Al₂O₃, B₂O₃, SC₂O₃, Cr₂O₃, REZrO, CeO₂, PrO₂, and RE₂O₃ (RE denotes a single rare earth element or a plurality of rare earth elements) mixed into a solution containing at least one of trifluoroacetic acid salt, naphthenic acid salt, octylic acid salt, levulinic acid salt, and neodecanoic acid salt. In this case, the material solution is not limited to these materials. For enhanced in-plane orientation, GZO, CeO₂, PrO₂, or the like is preferably used.

### The coating is carried out by a die coat method disclosed in Japanese

Patent Laid-Open No. 2010-274241. The die coat method is a technique for continuously moving an elongate base material (for example, the substrate 10 according to the present invention), while coating a material solution on a surface of the elongate base material using a coating dice with cavities arranged opposite the surface of the base material at predetermined intervals, thus depositing a thin film (a thin coating film).

The die coat method allows a thin film to be deposited on the surface of the elongated base material by controlling a load on the base material applied to the coating dice in order to keep a repulsive force from the material solution to the coating dice at a predetermined value while supplying the material solution into the cavity at a predetermined pressure. Thus, the die coat method allows a thin film with a highly accurate film thickness to be continuously deposited at high speed with scarcely being affected by a speed at which the elongate base material travels and recesses and protrusions on the surface of the elongate base material or the dice. Of course, the viscosity of the material solution for depositing a thin film can be appropriately changed.

Such a coating technique is used to deposit n thin coating film layers 21i (i = 1, 2, ... n) forming the first intermediate layer on the substrate 10 as shown in Figure 2. For example, for n = 2 to 10, 2 to 10 thin coating film layers 21i are deposited. The thin coating film layer 21i (i = 1, a first thin coating film layer) is closest to the deposition plane of the substrate 10, whereas the thin coating film layer 21i (i = n, the outermost thin coating film layer) is furthest to the substrate 10. For example, the thin coating film layers 21i may be deposited so that the layer with i = 1 (first thin coating film layer) has the largest film thickness and so that the film thickness increases consistently with the value of i (i = 2, 3, ... n), in other words, with increasing distance from the substrate 10. Varying the film thickness in this manner allows adjustment of the adhesiveness between the substrate 10 and the first intermediate layer 21 and the surface shape of the first intermediate layer 21. The large film thickness of the thin coating film layer 21i (i = 1, the first thin coating film layer) enables recesses and protrusions present on the surface of the substrate 10 to be eliminated, thus improving the adhesiveness. Additionally, the small film thickness of the thin coating film layer 21i (i = n, the outermost thin coating film layer) ensures the flatness of the outermost surface of the first intermediate layer 21.

Furthermore, the thin coating film layers 21i may be deposited so that the layer with i = 1 (first thin coating film layer) is deposited with a material solution with the highest viscosity and so that the viscosity of the material solution decreases increasing the value of i (i = 2, 3, ... n), in other words, with increasing distance from the substrate 10. Varying the viscosity of the material solution also allows adjustment of the adhesiveness between the substrate 10 and the first intermediate layer 21 and the surface shape of the first intermediate layer 21. The high viscosity of the material solution for the thin coating film layer 21i (i = 1, the first thin coating film layer) enables recesses and protrusions present on the surface (deposition plane) of the substrate 10 to be eliminated, thus improving the adhesiveness between the substrate 10 and the first intermediate layer 21. Additionally, the low viscosity of the material solution for the thin coating film layer 21i (i = n) ensures the flatness of the outermost surface of the first intermediate layer 21.

The first intermediate layer 21 with the plurality of thin coating film layers 21i is thus deposited on the surface (deposition plane) 10s of the substrate 10. This enables the surface smoothness of the first intermediate layer 21 to be made more appropriate than the surface smoothness of the surface (deposition plane) 10s of the substrate 10. For example, even when the deposition plane of the substrate 10 has a maximum height roughness (the maximum roughness of the surface 10s) Rz of 10 nm, the first intermediate layer 21 can be deposited to have a surface roughness (the roughness of the surface 21s) Ra of 5 nm or less. In this case, the maximum height roughness (surface maximum roughness) Rz of the deposition plane of the substrate 10 is preferably 10 nm or more in order to maintain adhesion strength. Furthermore, for the appropriate surface smoothness of the first intermediate layer 21, Rz is preferably 30 nm or less. Additionally, to further improve the surface smoothness of the first intermediate layer 21, Rz is preferably set to 20 nm or less. Here, an arithmetic average roughness Ra and the maximum height roughness Rz are based on Japanese Industrial Standards JIS B0601: 2001.

Although not particularly limited, the film thickness of the first intermediate layer 21 is preferably 300 nm or less so that the first intermediate layer 21 has an arithmetic average roughness Ra of 5 nm or less. Furthermore, the film thickness is preferably 1,000 nm or less in terms of costs. Additionally, the first intermediate layer 21 is more preferably 400 nm or more in film thickness in view of enhancement of the functions of the buffer layer and the orientation of the second intermediate layer 22, and is more preferably 800 nm or less in film thickness in view of suppression of warpage of the substrate 10.

Of course, even when the first intermediate layer 21 is 300 nm or less in film thickness, the arithmetic average roughness Ra of the first intermediate layer 21 can be set to 5 nm or less by adjusting the coating thickness of the thin coating film layer 21i in the first intermediate layer 21 and the viscosity of the material solution. Thus, the film thickness of the first intermediate layer 21 is not limited to 300 nm or more.

### Second intermediate layer

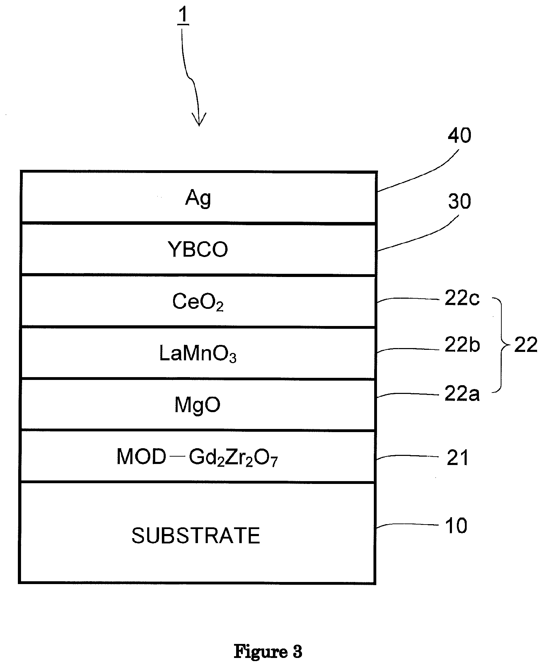

The second intermediate layer 22 has biaxial orientation and is deposited on the surface 21s of the first intermediate layer 21 to orient a crystal in the superconducting layer 30 in a given direction. As shown in Figure 3, the second intermediate layer 22 has a plurality of thin film layers including an MgO layer 22a, an LaMnO₃ layer 22b, and a CeO₂ layer 22c containing, for example, polycrystalline materials such as MgO, LaMnO₃, and CeO, as a main component. The second intermediate layer 22 may be partly or wholly formed of a forced orientation layer (particularly MgO in Figure 3). The forced orientation layer can be formed by the IBAD method. When the forced orientation layer is formed by the IBAD method, the surface of the first intermediate layer 21 with the forced orientation layer deposited therein is preferably an amorphous layer.

### Superconducting layer

The superconducting layer 30 is deposited on a surface 20s of the intermediate layer 20. The superconducting layer 30 is formed of an oxide superconductor and contains, for example, YBa₂Cu₃O_{7-δ} (hereinafter sometimes referred to as "YBCO") as a main component.

Alternatively, the superconducting layer 30 may contain, as a main component, an oxide expressed by a compositional formula such as Bi₂CaCu₂O_{8+δ} (including Bi₂CaCu₂O_{8+δ} with Pb doped into a Bi site), Bi₂CaCu₂O_{10+δ} (including Bi₂CaCu₂O_{10+δ} with Pb doped into a Bi site), (La,Ba)2CuO_{4-δ}, (Ca,Sr)CuO_{2-δ}[a Ca site may be replaced with Ba], (Nd,Ce)₂CuO_{4-δ}, (Cu,Mo)Sr₂(Ce,Y)sCu₂O [referred to as (Cu,Mo)-12s2, s = 1, 2, 3, or 4], Ba(Pb,Bi)O₃, or Tl₂Ba₂Caₙ₋₁CuₙO₂ₙ₊₄ (n is an integer of 2 or more).

### Protective layer

The protective layer 40 formed of a material such as rare metal, for example, silver or gold, or an alloy thereof is deposited on the surface of the superconducting layer 30 in order to protect the superconducting layer 30.

### Examples

A plurality of samples of the superconducting wire 1 shown in Table 1 was produced in order to examine relations between both the maximum height roughness Rz of the deposition plane of the substrate 10 and the arithmetic average roughness Ra of the surface of the first intermediate layer 21 and both the adhesive strength between the first intermediate layer 21 and the substrate 10 and a critical current Ic.

**[Table 1]**

| Sample | Substrate Rz | Bed Layer Ra | Bed layer adhesive strength | Ic |
|---|---|---|---|---|
| | nm | nm | kN/m | A |
| 1 | 6.1 | 1.2 | 0.05 | 332 |
| 2 | 6.1 | 1.9 | 0.05 | 283 |
| 3 | 6.1 | 4.2 | 0.05 | 248 |
| 4 | 6.1 | 6.1 | 0.05 | 65 |
| 5 | 6.1 | 7.9 | 0.04 | 32 |
| 6 | 8.8 | 0.9 | 0.06 | 347 |
| 7 | 8.8 | 2.1 | 0.07 | 295 |
| 8 | 8.8 | 4.1 | 0.07 | 279 |
| 9 | 8.8 | 6.1 | 0.06 | 102 |
| 10 | 8.8 | 8.1 | 0.05 | 10 |
| 11 | 10.8 | 0.9 | 0.12 | 348 |
| 12 | 10.8 | 1.9 | 0.11 | 326 |
| 13 | 10.8 | 3.9 | 0.10 | 233 |
| 14 | 10.8 | 5.9 | 0.11 | 100 |
| 15 | 10.8 | 8.0 | 0.12 | 11 |
| 16 | 14.1 | 1.2 | 0.13 | 355 |
| 17 | 14.1 | 2.0 | 0.12 | 282 |
| 18 | 14.1 | 3.9 | 0.14 | 242 |
| 19 | 14.1 | 6.0 | 0.13 | 82 |
| 20 | 14.1 | 7.8 | 0.13 | 5 |
| 21 | 18.0 | 0.8 | 0.15 | 320 |
| 22 | 18.0 | 1.8 | 0.15 | 293 |
| 23 | 18.0 | 3.9 | 0.15 | 265 |
| 24 | 18.0 | 6.2 | 0.15 | 46 |
| 25 | 18.0 | 7.9 | 0.15 | 22 |

### Substrate and the surface roughness thereof

The substrate 10 of the superconducting wire 1 was HASTELLOY C-276 (registered trade mark) rolled into a width of 1 cm and a thickness of 0.1 mm. The maximum height roughness Rz of the deposition plane of the substrate 10 was set to 6 nm to 18 nm (five groups for 6 nm, 9 nm, 11 nm, 14 nm, and 18 nm (the digits after the decimal point are dropped for all values)) by, for example, appropriately selecting the surface roughness (for example, the arithmetic average roughness Ra) of a rolling mill roll.

The maximum height roughness Rz was measured in an area of X x Y = 1.54 µm x 1.54 µm using an atomic force microscope (Nanosurf (registered trade mark) Mobile S manufactured by Nanosurf AG).

### First intermediate layer and adhesive strength

The first intermediate layer 21 was deposited on the surface (deposition plane) 10s of the substrate 10 by the die coat method using a material solution of metallic organic acid salt containing a rare earth oxide Gd₂Zr₂O₇. The first intermediate layer 21 was formed by carrying out deposition based on coating, and after a drying step, performing thermal treatment in an atmospheric environment at 550°C.

A first intermediate layer 21 with 2 to 10 thin coating film layers 21i was deposited by coating the material solution twice to ten times. At this time, the plurality of thin coating film layers 21i was deposited so that the film thickness of the thin coating film layer 21i decreased with increasing distance from the deposition plane of the substrate 10 (Figure 2). The material solution had a viscosity of 0.005 Pa·s. Thus, a plurality of superconducting wires 1 with the first intermediate layer 21 having an arithmetic average roughness Ra of 0.8 nm to 8.1 nm was produced by adjusting the number of coating operations (Table 1). At this time, 10 coating operations were performed on a sample with the surface of the first intermediate layer 21 having the lowest arithmetic average roughness Ra. Two coating operations were performed on the sample with a surface of the first intermediate layer 21 having the highest arithmetic average roughness Ra. XRD was used to confirm that the first intermediate layer 21 was formed of an amorphous layer.

Some of the superconducting wires 1 were sampled, and the adhesive strength (peel strength) between the substrate 10 and the first intermediate layer 21 was measured. For the adhesive strength, in 15 samples (samples 11 to 25) with the deposition plane of the substrate 10 having a maximum height roughness Rz of 10 nm or more, a high adhesive strength (0.10 kN/m or more) was obtained between the substrate 10 and the intermediate layer 20 (first intermediate layer 21). An increased roughness of the surface (deposition plane) of the substrate 10 is expected to increase the adhesive strength due to what is called an anchor effect.

The adhesive strength (peel strength) was measured using a peel strength measuring apparatus SAICAS (registered trade mark) type NN manufactured by DAIPLA WINTES CO., LTD.

### Second intermediate layer

The MgO layer 22a in the second intermediate layer 22 is a forced orientation layer and functions to orient the crystal in the superconducting layer 30 in a given direction. The MgO layer 22a contains a polycrystalline material of MgO as a main component and is deposited to a film thickness of 3 nm by the IBAD method.

The LMO layer 22b is deposited between the MgO layer 22a and the CeO₂ layer 22c, and functions to improve the lattice matching capability of the CeO₂ layer 22c. The LMO layer 22b is formed of a crystal material expressed by a compositional formula LaMnO_{3+δ} (δ denotes an oxygen non-stoichiometry, for example, -1 < δ < 1). The LMO layer 22b is deposited to a film thickness of 15 nm by a sputtering method.

The CeO₂ layer 22c is a cap layer deposited on a surface of the LMO layer 22b and functions to protect the LMO layer 22b and to further improve the lattice matching capability of the superconducting layer 30. The CeO₂ layer 22c is deposited to a film thickness of 500 nm by the sputtering method. The cap layer is formed of a fluorite type crystal structure containing a rare earth element and having self-orientation. Besides CeO₂, PrO₂ can be used as the fluorite type crystal structure.

### Superconducting layer

The superconducting layer 30 contains YBCO as a main component and is deposited on the surface of the second intermediate layer 22 (that is, the surface 20s of the intermediate layer) to a film thickness of 1 µm by an MOCVD method. As the protective layer 40, an Ag layer with a film thickness of 10 µm is deposited on a surface 30s of the superconducting layer 30.

### Measurement of the critical current

The critical current Ic was measured using a four-terminal method with the superconducting wire 1 immersed in liquid nitrogen (temperature: 77K). In the measurement of the critical current Ic, voltage terminal distance is 1 cm, and electric field reference is 1 µV/cm.

### Critical current, adhesive strength, and surface roughness

As a result of measurements, a high critical current (Ic = 200 A) was obtained in 15 samples (samples 1 to 3, 6 to 8, 11 to 13, 16 to 18, and 21 to 23) with the surface of the first intermediate layer 21 having an arithmetic average roughness Ra of 5 nm or less.

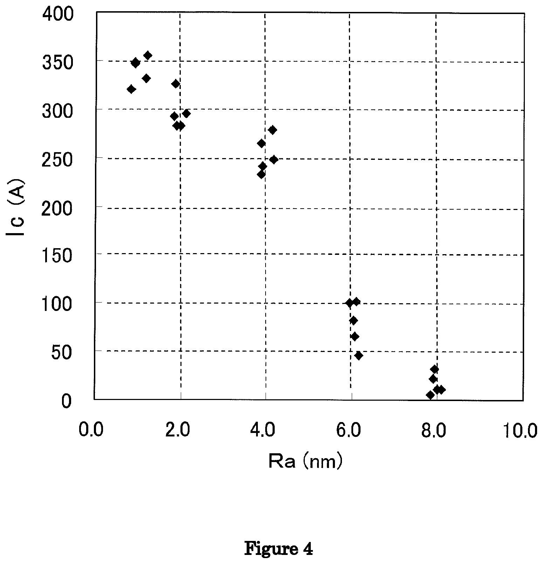

Figure 4 shows relations between the arithmetic average roughness Ra of the first intermediate layer 21 (the axis of abscissas: denoted by Ra (nm)) and the critical current Ic in the superconducting wire 1 (the axis of ordinate: denoted by Ic(A) in Figure 4). Here, the following correlation is present between the arithmetic average roughness Ra of the surface of the first intermediate layer 21 and the critical current Ic in the superconducting wire 1: the critical current Ic increases with decreasing arithmetic average roughness Ra of the surface of the first intermediate layer 21.

In a plurality of samples with the surface of the first intermediate layer 21 having an arithmetic average roughness Ra of about 4 nm or less, the critical current is about 230 A or more (the critical current in sample 13 is 233 A). On the other hand, in a plurality of samples with the surface of the first intermediate layer 21 having an arithmetic average roughness Ra of about 6 nm or more, the critical current is about 100 A or less (the critical current in sample 9 is 102 A). Thus, a significant difference in critical current property (a difference, in critical current, of about 130 A or more) is present between the two groups of samples. Figure 4 also shows a significant gap in critical current between the surface of the first intermediate layer 21 having an arithmetic average roughness Ra of about 4 nm or less and the surface of the first intermediate layer 21 having an arithmetic average roughness Ra of about 6 nm or more. Thus, the surface of the first intermediate layer 21 is preferably 5 nm or less in arithmetic average roughness Ra.

Of the 15 samples with the high critical current, 9 samples (samples 11 to 13, 16 to 18, and 21 to 23) with the deposition plane of the substrate 10 having a maximum height roughness Rz of 10 nm or more exhibited an appropriate adhesive strength (0.10 kN/m or more). Hence, the 9 samples exhibited the high critical current and the appropriate adhesive strength.

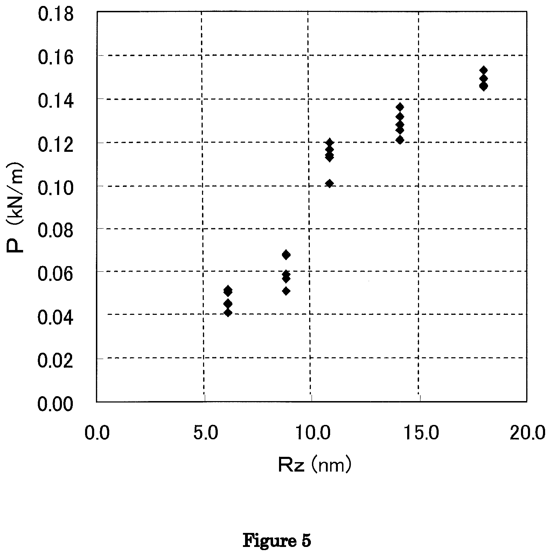

Figure 5 shows relations between the maximum height roughness Rz of the deposition plane of the substrate 10 in the superconducting wire 1 (the axis of abscissas: denoted by Rz (nm)) and the peel strength (the axis of ordinate: P(kN/m)). Here, the following correlation is present between the maximum height roughness Rz of the deposition plane of the substrate 10 and the adhesive strength (peel strength): the adhesive strength (peel strength) P increases consistently with the maximum height roughness Rz.

A plurality of samples with the deposition plane of the substrate 10 having a maximum height roughness Rz of about 6 nm and about 9 nm had a peel strength of about 0.07 kN/m or less (samples 7 and 8 had a peel strength of 0.07 kN/m). On the other hand, a plurality of samples with the deposition plane of the substrate 10 having a maximum height roughness Rz of about 11 nm, 14 nm, and 18 nm had a peel strength of about 0.10 kN/m or more (sample 13 has a peel strength of 0.10 kN/m). Thus, a significant difference in adhesive strength (peel strength) is present between the two groups. Figure 5 also shows a significant gap in adhesive strength between the deposition plane of the substrate 10 having a maximum height roughness Rz of about 10 nm or less and the deposition plane of the substrate 10 having a maximum height roughness Rz of about 10 nm or more. Thus, the deposition plane of the substrate 10 is preferably 10 nm or more in maximum height roughness Rz.

Of the 9 samples with the high critical current and the appropriate adhesive strength, 6 samples (samples 11, 12, 16, 17, 21, and 22) with the first intermediate layer 21 having an arithmetic average roughness Ra of 3 nm or less provide a critical current Ic of 282 A (sample 17) to 355 A (sample 16) and exhibit a more appropriate critical current property.

Of the 6 samples, 3 samples (samples 11, 16, and 21) with the surface of the first intermediate layer 21 having an arithmetic average roughness Ra of 1.5 nm or less provide a critical current Ic of 320 A (sample 21) to 355 A (sample 16) and exhibit a much more appropriate critical current property.

Thus, for the superconducting wire 1, selection of the surface roughness (arithmetic average roughness Ra) of a rolling mill roll allows the substrate 10 to be rolled so that the deposition plane of the substrate 10 has a maximum height roughness Rz of 10 nm or more, providing a high adhesive strength. Furthermore, the surface roughness Ra of the first intermediate layer 21 can be set to 5 nm or less, preferably 3 nm or less, and more preferably 1.5 nm, enabling an appropriate critical current property to be achieved.

For the superconducting wire 1, the surface of the first intermediate layer 21 preferably has as low arithmetic average roughness Ra as possible. For example, an increased number of thin coating film layers 21i in the first intermediate layer 21 enables a reduction in the surface roughness Ra of the first intermediate layer 21. Furthermore, the superconducting wire 1 can achieve an appropriate critical current property even when the deposition plane of the substrate 10 is 10 nm or more in maximum height roughness Rz. For example, even if the deposition plane of the substrate 10 is 30 nm or more in maximum height roughness Rz, the arithmetic average roughness Ra of the surface of the first intermediate layer 21 can be reduced by increasing the number of thin coating film layers 21i in the intermediate layer 21.

In any case, the maximum height roughness Rz of the deposition plane of the substrate 10 and the arithmetic average roughness Ra of the surface of the first intermediate layer 21 can be determined taking into account the cost of an increase in the number of the thin coating film layers 21i in the first intermediate layer 21.

The superconducting wire according to the present invention is not limited to the above-described embodiment, and can be implemented by making appropriate modifications within the scope of the present invention defined by the claims.

For example, when a material solution is coated a number of times to deposit a first intermediate layer 21 with a plurality of thin coating film layers 21i, the viscosity of the material solution used for the plurality of thin coating film layers 21i may decrease with increasing distance from the deposition plane of the substrate 10. In this case, the viscosity of the material solution used is preferably 0.0005 Pa·s to 0.05 Pa·s and more preferably 0.001 Pa·s to 0.01 Pa·s. In particular, the viscosity may be adjusted depending on the number of the thin coating film layers 21i. Moreover, preferably, the outermost surface can be made smoother by adjusting the film thickness of each layer.

### Reference Signs List

- 1: Superconducting line
- 10: Substrate
- 10s: Surface (deposition plane) of substrate
- 20: Intermediate layer
- 20s: Surface of intermediate layer
- 21: First intermediate layer
- 21i: Thin coating film layer
- 21s: Surface of first intermediate layer
- 22: Second intermediate layer
- 22a: Forced orientation layer
- 30: Oxide superconducting layer (superconducting layer)
- 40: Protective layer (stabilizing layer)

## Claims

1. A superconducting wire (1) comprising:
a substrate (10) having a deposition plane with a surface (10s);
an intermediate layer (20) having a first intermediate layer (21) with a coating film formed on the deposition plane and a second biaxially oriented intermediate layer (22) formed on the first intermediate layer (21); and
an oxide superconducting layer (30) formed on the intermediate layer (20),
**characterised in that** the surface has a maximum height roughness Rz, according to B0601:2001, of 10 nm to 18 nm.

2. The superconducting wire according to Claim 1, wherein the surface (21s) of the first intermediate layer (21) has an arithmetic average roughness Ra of 5 nm or less.

3. The superconducting wire according to Claim 1 or Claim 2, wherein the first intermediate layer (21) comprises a plurality of thin coating films (21i), and an outermost thin coating film layer (21i) formed at an outermost surface of the first intermediate layer (21) is formed to be thinner than a first thin coating film layer (21i) formed on the deposition plane.

4. The superconducting wire according to any one of Claims 1 to 3, wherein the first intermediate layer (21) comprises a plurality of thin coating film layers (21i), and the plurality of thin coating film layers (21i) is formed such that a film thickness of the thin coating film layer (21i) decreases with increasing distance from the surface (10s) of the deposition plane.

5. The superconducting wire according to any one of Claims 1 to 4, wherein the first intermediate layer (21) has a film thickness of 300 nm to 1,000 nm.

6. A method for manufacturing a superconducting wire (1), the method comprising:
a step of coating a material solution on a deposition plane of a substrate (10) to form a first intermediate layer (21), the deposition plane having a surface (10s);
a step of forming a biaxially oriented second intermediate layer (22) on the first intermediate layer (21); and
a step of forming an oxide superconducting layer (30) on the second intermediate layer (22),
**characterised in that** the surface has a maximum height roughness Rz, according to JIS B0601:2001, of 10 nm to 18 nm.

7. The method for manufacturing the superconducting wire according to Claim 6, wherein the step of forming the first intermediate layer (21) comprises a thin coating film layer forming step of forming a plurality of thin coating film layers (21i), and
the thin coating film layer forming step comprises forming a plurality of the thin coating film layers (21i) such that a film thickness of the thin coating film layer (21i) formed decreases with increasing distance between the thin coating film layer (21i) and the deposition plane.

8. The method for manufacturing the superconducting wire according to Claim 6, wherein the step of forming the first intermediate layer (21) comprises a thin coating film layer forming step of forming a plurality of thin coating film layers (21i), and
in the thin coating film layer forming step, a material solution used for a first thin coating film layer (21i) formed on the deposition plane has a higher viscosity than a material solution used for an outermost thin coating film layer (21i) formed at an outermost surface of the first intermediate layer (21).

9. The method for manufacturing the superconducting wire according to any one of Claims 6 to 8, wherein the thin coating film layer (21i) comprises an amorphous film, and in the step of forming the second intermediate layer (22), at least a part of the second intermediate layer (22) is formed by an ion beam assisted deposition method.

10. The method for manufacturing the superconducting wire according to any one of Claims 6 to 9, wherein, in the thin coating film layer forming step, the thin coating film layer (21i) is formed by a MOD method.

## Patentansprüche

1. Supraleitender Draht (1), umfassend:
ein Substrat (10), welches eine Abscheidefläche mit einer Oberfläche (10s) aufweist;
eine Zwischenschicht (20), welche eine erste Zwischenschicht (21) mit einem auf der Abscheidefläche gebildeten Beschichtungsfilm und eine auf der ersten Zwischenschicht (21) gebildete zweite biaxial orientierte Zwischenschicht (22) aufweist; und
eine auf der Zwischenschicht (20) gebildete supraleitende Oxidschicht (30), **dadurch gekennzeichnet, dass** die Oberfläche eine maximale Höhenrauheit Rz gemäß JIS B0601:2001 zwischen 10 nm und 18 nm aufweist.

2. Supraleitender Draht nach Anspruch 1, wobei die Oberfläche (21s) der ersten Zwischenschicht (21) einen arithmetischen Mittenrauwert Ra von 5 nm oder weniger aufweist.

3. Supraleitender Draht nach Anspruch 1 oder 2, wobei die erste Zwischenschicht (21) eine Vielzahl von dünnen Beschichtungsfilmen (21i) umfasst, und eine äußerste dünne Beschichtungsfilmschicht (21i), die an einer äußersten Oberfläche der ersten Zwischenschicht (21) gebildet ist, dünner als eine erste dünne Beschichtungsfilmschicht (21i) ist, die auf der Abscheidefläche gebildet ist.

4. Supraleitender Draht nach einem der Ansprüche 1 bis 3, wobei die erste Zwischenschicht (21) eine Vielzahl von dünnen Beschichtungsfilmen (21i) umfasst, und die Vielzahl von dünnen Beschichtungsfilmen (21i) derart gebildet ist, dass eine Filmdicke der dünnen Beschichtungsfilmschicht (21i) mit zunehmenden Abstand von der Oberfläche (10s) der Abscheidefläche abnimmt.

5. Supraleitender Draht nach einem der Ansprüche 1 bis 4, wobei die erste Zwischenschicht (21) eine Filmdicke zwischen 300 nm und 1.000 nm aufweist.

6. Verfahren zum Herstellen eines supraleitenden Drahts (1), wobei das Verfahren umfasst:
einen Schritt zum Beschichten einer Abscheidefläche eines Substrats (10) mit einer Materiallösung zum Bilden einer ersten Zwischenschicht (21), wobei die Abscheidefläche eine Oberfläche (10s) aufweist;
einen Schritt zum Bilden einer biaxial orientierten zweiten Zwischenschicht (22) auf der ersten Zwischenschicht (21); und
einen Schritt zum Bilden einer supraleitenden Oxidschicht (30) auf der zweiten Zwischenschicht (22),
**dadurch gekennzeichnet, dass** die Oberfläche eine maximale Höhenrauheit Rz gemäß JIS B0601:2001 zwischen 10 nm und 18 nm aufweist.

7. Verfahren zum Herstellen des supraleitenden Drahts nach Anspruch 6, wobei der Schritt zum Bilden der ersten Zwischenschicht (21) einen Schritt zum Bilden einer dünnen Beschichtungsfilmschicht, bei dem eine Vielzahl von dünnen Beschichtungsfilmschichten (21i) gebildet werden, umfasst; und
der Schritt zum Bilden einer dünnen Beschichtungsfilmschicht das Bilden einer Vielzahl von dünnen Beschichtungsfilmschichten (21i) derart, dass eine Filmdicke der gebildeten dünnen Beschichtungsfilmschicht (21i) mit zunehmenden Abstand zwischen der dünnen Beschichtungsfilmschicht (21i) und der Abscheidefläche abnimmt, umfasst.

8. Verfahren zum Herstellen des supraleitenden Drahts nach Anspruch 6, wobei der Schritt zum Bilden der ersten Zwischenschicht (21) einen Schritt zum Bilden einer dünnen Beschichtungsfilmschicht, bei dem eine Vielzahl von dünnen Beschichtungsfilmschichten (21i) gebildet werden, umfasst; und
eine Materiallösung, die bei einer auf der Abscheidefläche gebildeten ersten dünnen Beschichtungsfilmschicht (21i) benutzt wird, in dem Schritt zum Bilden einer dünnen Beschichtungsfilmschicht eine höhere Viskosität als eine Materiallösung, die bei einer auf einer äußersten Oberfläche der ersten Zwischenschicht (21) gebildeten äußersten dünnen Beschichtungsfilmschicht (21i) benutzt wird.

9. Verfahren zum Herstellen des supraleitenden Drahts nach einem der Ansprüche 6 bis 8, wobei die dünne Beschichtungsfilmschicht (21i) einen amorphen Film umfasst, und in dem Schritt zum Bilden der zweiten Zwischenschicht (22) zumindest ein Teil der zweiten Zwischenschicht (22) durch ein Ionenstrahl unterstütztes Depositionsverfahren gebildet wird.

10. Verfahren zum Herstellen des supraleitenden Drahts nach einem der Ansprüche 6 bis 9, wobei die dünne Beschichtungsfilmschicht (21i) in dem Schritt zum Bilden der dünnen Beschichtungsfilmschicht durch ein metallorganisches Abscheidungsverfahren gebildet wird.

## Revendications

1. Fil supraconducteur (1), comprenant:
un substrat (10) ayant un plan de dépôt avec une surface (10s) ;
une couche intermédiaire (20) ayant une première couche intermédiaire (21) avec un film de revêtement formé sur le plan de dépôt et une deuxième couche intermédiaire (22) biaxialement orientée formée sur la première couche intermédiaire (21) ; et
une couche d'oxyde supraconductrice (30) formée sur la couche intermédiaire (20), **caractérisé en ce que** la surface a une rugosité de profil maximal Rz selon JIS B0601:2001 entre 10 nm et 18 nm.

2. Fil supraconducteur selon la revendication 1, dans lequel la surface (21s) de la première couche intermédiaire (21) a une rugosité moyenne arithmétique Ra de 5 nm ou moins.

3. Fil supraconducteur selon la revendication 1 ou 2, dans lequel la première couche intermédiaire (21) comprend une pluralité de films de revêtement fin (21i), et une couche de film de revêtement fin (21i) la plus externe formée sur une surface la plus externe de la première couche intermédiaire (21) est plus fine qu'une couche de film de revêtement fin (21i) formé sur le plan de dépôt.

4. Fil supraconducteur selon l'une des revendications 1 à 3, dans lequel la première couche intermédiaire (21) comprend une pluralité de couches de film de revêtement fin (21i), et la pluralité de couches de film de revêtement fin (21i) est formée de sorte qu'une épaisseur de la couche de film de revêtement fin (21i) diminue avec une distance croissante de la surface (10s) du plan de dépôt.

5. Fil supraconducteur selon l'une des revendications 1 à 4, dans lequel la première couche intermédiaire (21) a une épaisseur de film entre 300 nm et 1000 nm.

6. Procédé pour fabriquer un fil supraconducteur (1), le procédé comprenant :
une étape de revêtement d'un plan de dépôt d'un substrat (10) d'une solution matérielle pour former une première couche intermédiaire (21), le plan de dépôt ayant une surface (10s) ;
une étape de formation d'une deuxième couche intermédiaire (22) biaxilement orientée sur la première couche intermédiaire (21) ; et
une étape de formation d'une couche d'oxyde supraconductrice (30) sur la deuxième couche intermédiaire (22), **caractérisé en ce que** la surface a une rugosité de profil maximal Rz selon JIS B0601:2001 entre 10 nm et 18 nm.

7. Procédé pour fabriquer un fil supraconducteur selon la revendication 6, dans lequel l'étape de formation de la première couche intermédiaire (21) comprend une étape de formation d'une couche de film de revêtement fin pour former une pluralité de couches de film de revêtement fin (21i), et
l'étape de formation d'une couche de film de revêtement fin comprend la formation d'une pluralité de couches de film de revêtement fin (21i) de sorte qu'une épaisseur de film de la couche de film de revêtement fin (21i) formée diminue avec une distance croissante entre la couche de film de revêtement fin (21i) et le plan de dépôt.

8. Procédé pour fabriquer un fil supraconducteur selon la revendication 6, dans lequel l'étape de formation de la première couche intermédiaire (21) comprend une étape de formation d'une couche de film de revêtement fin pour former une pluralité de couches de film de revêtement fin (21i), et
dans l'étape de formation d'une couche de film de revêtement fin, une solution matérielle utilisée pour une première couche de film de revêtement fin (21i) formé sur le plan de dépôt a une viscosité supérieure à celle d'une solution matérielle utilisée pour une couche de film de revêtement fin (21i) la plus externe formée sur une surface la plus externe de la première couche intermédiaire (21).

9. Procédé pour fabriquer un fil supraconducteur selon l'une des revendications 6 à 8, dans lequel la couche de film de revêtement fin (21i) comprend un film amorphe, et dans l'étape de formation de la deuxième couche intermédiaire (22), au moins une partie de la deuxième couche intermédiaire (22) est formée par un procédé de dépôt assisté par faisceau d'ions.

10. Procédé pour fabriquer un fil supraconducteur selon l'une des revendications 6 à 9, dans lequel, dans l'étape de formation d'une couche de film de revêtement fin, la couche de film de revêtement fin (21i) est formée par une méthode de dépôt métallo-organique.
